(19) Europäisches Patentamt
European Patent Office
Office européen des brevets

(11) **EP 3 730 670 A1**

(12) **EUROPEAN PATENT APPLICATION**
published in accordance with Art. 153(4) EPC

(43) Date of publication:
**28.10.2020 Bulletin 2020/44**

(51) Int Cl.:
*C23C 14/34* (2006.01)    *B22F 3/10* (2006.01)
*C22C 1/04* (2006.01)    *C22C 1/05* (2006.01)
*C22C 9/00* (2006.01)    *H01L 31/0749* (2012.01)

(21) Application number: **18892115.9**

(22) Date of filing: **18.12.2018**

(86) International application number:
**PCT/JP2018/046519**

(87) International publication number:
**WO 2019/124351 (27.06.2019 Gazette 2019/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.12.2017 JP 2017246340**

(71) Applicant: **Mitsubishi Materials Corporation
Tokyo 100-8117 (JP)**

(72) Inventors:
• **MORI Satoru
Saitama-shi, Saitama 330-8508 (JP)**
• **TAKEDA Takuma
Naka-shi, Ibaraki 311-0102 (JP)**

(74) Representative: **Hoffmann Eitle
Patent- und Rechtsanwälte PartmbB
Arabellastraße 30
81925 München (DE)**

(54) **CU-GA ALLOY SPUTTERING TARGET, AND METHOD FOR MANUFACTURING CU-GA ALLOY SPUTTERING TARGET**

(57)    Provided is a Cu-Ga alloy sputtering target containing, as a composition: Ga in a range of 20 atom% or greater and 40 atom% or less as a metal component; Na and K in a range of 0.05 atom% or greater and 1.0 atom% or less in total; and a remainder consisting of Cu and inevitable impurities, in which alkali metal salt grains formed of a sodium salt or a potassium salt are dispersed in a matrix of the Cu-Ga alloy, the alkali metal salt grains have a maximum grain size of 30 $\mu$m or less, and a relative density is 97% or greater.

**Description**

[Technical Field]

The present invention relates to a Cu-Ga alloy sputtering target for use in forming, for example, a Cu-In-Ga-Se compound film (hereinafter, abbreviated as a CIGS film) to be a light-absorbing layer of a CIGS solar cell, and a method for manufacturing the Cu-Ga alloy sputtering target.
Priority is claimed on Japanese Patent Application No. 2017-246340, filed December 22, 2017, the content of which is incorporated herein by reference.

[Background Art]

CIGS-based solar cells provided with a light-absorbing layer formed of a CIGS film have been provided as thin film solar cells made of a compound semiconductor.
As a method for forming a light-absorbing layer formed of a CIGS film, a deposition method using vapor deposition has been known. A solar cell provided with a light-absorbing layer deposited by vapor deposition is advantageous in that the energy exchange efficiency thereof is high, but is not suitable for increasing the area and has a problem of low production efficiency. In addition, there is a problem in that the uniformity of the film thickness distribution is likely to decrease.
Accordingly, a method for forming a light-absorbing layer formed of a CIGS film by a sputtering method has been proposed.
In the sputtering method, first, an In film is deposited using an In sputtering target, and a Cu-Ga alloy film is deposited on the In film using a Cu-Ga alloy sputtering target to form a multilayer film of the In film and the Cu-Ga alloy film. Selenization of the multilayer film is performed by heat-treating the multilayer film in a Se atmosphere, and thus a CIGS film is formed.
It is known that by adding an alkali metal such as Na or K to the CIGS film to be a light-absorbing layer as shown in Non Patent Literature 1, the conversion efficiency of a solar cell is improved.
As means for adding an alkali metal to the CIGS film, for example, Patent Literature 1 discloses that Na is added to a Cu-Ga alloy sputtering target for use in depositing a Cu-Ga alloy film, and Patent Literature 2 proposes that K is added to a Cu-Ga alloy sputtering target.

[Citation List]

[Patent Literature]

   [Patent Literature 1]
   Japanese Unexamined Patent Application, First Publication No. 2015-140452
   [Patent Literature 2]
   Japanese Unexamined Patent Application, First Publication No. 2016-028173

[Non Patent Literature]

[Non Patent Literature 1] Adrian Chirila, et al; Potassium-induced surface modification of Cu (In, Ga) Se2 thin films for high-efficiency solar cells; NATURE MATERALS, vol.12, DECEBER (2013)

[Summary of Invention]

[Technical Problem]

In a case where an alkali metal such as Na or K is added to a sputtering target, an alkali metal salt such as selenide, sulfide, chloride, or fluoride is used. However, since these alkali metal salts have high hygroscopicity, sinterability is reduced by moisture due to moisture absorption in a case where these alkali metal salt grains are used as a raw material for sintering. Accordingly, it was not possible to obtain a high-density sintered body.
An alkali metal salt has an insulating property. Thus, in a case where a coarse alkali metal salt exists in a sputtering target, there is a tendency that abnormal discharge may occur during sputtering.
As described above, in a case where an alkali metal salt is added to a sputtering target, the strength is insufficient due to a low density, and abnormal discharge is more likely to occur. Accordingly, there is a problem that cracks are likely to occur during use, and the life of the sputtering target is shortened.

The present invention has been contrived in view of the above-described circumstances, and an object thereof is to provide a Cu-Ga alloy sputtering target containing Na and K, having a high density, suppressing the occurrence of abnormal discharge, and achieving a longer life, and a method for manufacturing the Cu-Ga alloy sputtering target.

[Solution to Problem]

In order to solve the problems, according to the present invention, provided is a Cu-Ga alloy sputtering target containing, as a composition: Ga in a range of 20 atom% or greater and 40 atom% or less as a metal component; Na and K in a range of 0.05 atom% or greater and 1.0 atom% or less in total; and a remainder consisting of Cu and inevitable impurities, in which alkali metal salt grains formed of a sodium salt and a potassium salt are dispersed in a matrix of the Cu-Ga alloy, the alkali metal salt grains have a maximum grain size of 15 $\mu$m or less, and a relative density is 97% or greater.

According to the Cu-Ga alloy sputtering target having the above configuration, since K and Na are contained in a range of 0.05 atom% or greater and 1.0 atom% or less in total, a Cu-Ga alloy film containing Na and K can be deposited.

In addition, since alkali metal salt grains formed of a sodium salt and a potassium salt are dispersed in the matrix of the Cu-Ga alloy, and the alkali metal salt grains have a maximum grain size of 30 $\mu$m or less, it is possible to suppress the occurrence of abnormal discharge caused by the alkali metal salt grains.

Furthermore, since the relative density is 97% or greater, the strength of the target itself can be secured.

Accordingly, since the strength is secured and the occurrence of abnormal discharge is suppressed, the life of the Cu-Ga alloy sputtering target can be extended.

In The Cu-Ga alloy sputtering target according to the present invention, it is preferable that, in a case where a density is measured at a plurality of positions to obtain a maximum density $\rho_{max}$, a minimum density $\rho_{min}$, and an average density $\rho_{ave}$, and a larger one of $|\rho_{max}-\rho_{ave}|$ and $|\rho_{ave}-\rho_{min}|$ is represented by $\rho_A$, a variation in density defined by $\rho_A/\rho_{ave}\times100$ is 5% or less of the average $\rho_{ave}$.

In this case, since the variation in density is suppressed as described above, there is no local low-strength portion, and the life of the Cu-Ga alloy sputtering target can be reliably extended.

In the Cu-Ga alloy sputtering target according to the present invention, it is preferable that a Na content is measured at a plurality of positions, and both a difference between a measured maximum Na content and an average Na content and a difference between the average Na content and a minimum Na content are 0.05 atom% or less.

In this case, in the Cu-Ga alloy sputtering target, since the difference in the Na content is suppressed to be small, a Cu-Ga alloy film uniformly containing Na can be deposited. Accordingly, the performance of a solar cell using the Cu-Ga alloy film can be stably improved.

In the Cu-Ga alloy sputtering target according to the present invention, it is preferable that a K content is measured at a plurality of positions, and both a difference between a measured maximum K content and an average K content and a difference between the average K content and a minimum K content are 0.05 atom% or less.

In this case, in the Cu-Ga alloy sputtering target, since the difference in the K content is suppressed to be small, a Cu-Ga alloy film uniformly containing K can be deposited. Accordingly, the performance of a solar cell using the Cu-Ga alloy film can be stably improved.

In the Cu-Ga alloy sputtering target according to the present invention, it is preferable that an oxygen content is 1,000 ppm by mass or less.

In this case, since the oxygen content is limited to 1,000 ppm by mass or less, there are not many unsintered portions where sintering has not been sufficiently performed, and the density can be sufficiently increased.

One method for manufacturing a Cu-Ga alloy sputtering target according to the present invention is a method for manufacturing the above-described Cu-Ga alloy sputtering target, including: a raw material powder forming step of obtaining a raw material powder including a sodium salt powder and a potassium salt powder; a molded body forming step of forming a molded body of the raw material powder; a reduction step of heating and reducing the molded body in a reducing atmosphere; and a sintering step of subjecting the molded body after the reduction step to pressureless sintering, in which in the reduction step, a heating temperature is in a range of 550°C or more and 650°C or less, and a holding time at the heating temperature is in a range of 15 hours or greater and 60 hours or less, and in the sintering step, a sintering temperature is in a range of 750°C or more and 850°C or less, and a holding time at the sintering temperature is in a range of 1 hour or greater and 10 hours or less. The holding time at the heating temperature in the reduction step is preferably 20 hours or more and 55 hours or less, and more preferably 25 hours or more and 50 hours or less.

According to the method for manufacturing the Cu-Ga alloy sputtering target having the above configuration, the reduction step of heating and reducing the molded body in a reducing atmosphere is included, whereby even in a case where the molded body contains moisture due to moisture absorption, the moisture can be removed and an oxide film on the surface of the raw material powder can be removed in the reduction step. Accordingly, in the subsequent sintering step, sintering of the raw material powder grains can be promoted, and a high-density Cu-Ga alloy sputtering target can be obtained.

In addition, since the heating temperature is 550°C or more and 650°C or less in the reduction step and the holding time at the heating temperature is 15 hours or greater and 60 hours or less, it is possible to suppress evaporation of the sodium salt and potassium salt powder contained in the molded body, and a Cu-Ga alloy sputtering target containing a predetermined amount of Na and K can be obtained.

[Advantageous Effects of Invention]

According to the present invention, it is possible to provide a Cu-Ga alloy sputtering target containing Na and K, having a high density, suppressing the occurrence of abnormal discharge, and achieving a longer life, and a method for manufacturing the Cu-Ga alloy sputtering target.

[Brief Description of Drawings]

Fig. 1 shows schematic explanatory views of a Cu-Ga alloy sputtering target according to an embodiment of the present invention. Fig. 1(a) is a cross-sectional view orthogonal to a direction of an axis O, Fig. 1(b) is a cross-sectional view taken along the axis O, and Fig. 1(c) is an explanatory view showing measurement positions of a density, a Na content, and a K content.

Fig. 2 is a scanning electron microscopic image of a Cu-Ga alloy sputtering target according to an embodiment of the present invention.

Fig. 3 is a flowchart showing a method for manufacturing the Cu-Ga alloy sputtering target according to the present embodiment.

Fig. 4 is a schematic explanatory view of a Cu-Ga alloy sputtering target according to another embodiment of the present invention.

Fig. 5 is a schematic explanatory view of a Cu-Ga alloy sputtering target according to a further embodiment of the present invention.

[Description of Embodiments]

Hereinafter, a Cu-Ga alloy sputtering target and a method for manufacturing the Cu-Ga alloy sputtering target according to an embodiment of the present invention will be described with reference to the accompanying drawings.

For example, the Cu-Ga alloy sputtering target according to the present embodiment is used in a case where a Cu-Ga alloy film is deposited by sputtering in order to form a light-absorbing layer formed of a CIGS film in a CIGS-based thin film solar cell.

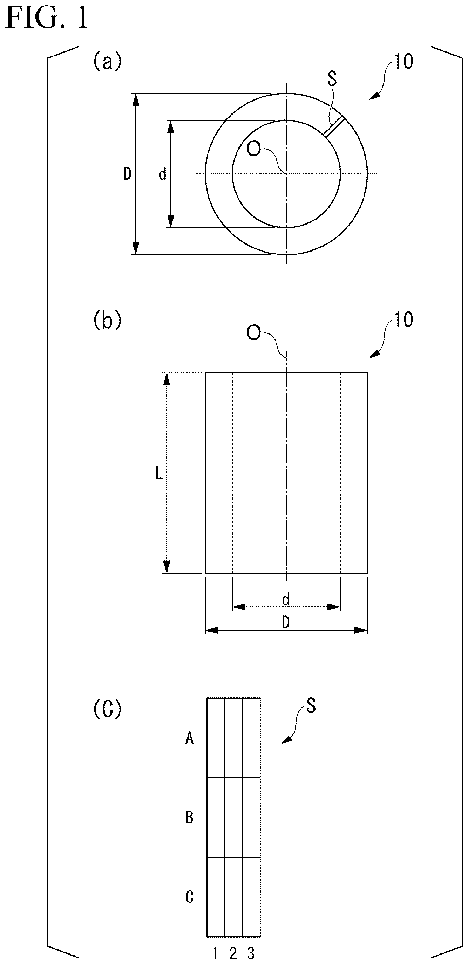

A Cu-Ga alloy sputtering target 10 according to the present embodiment has a hollow portion as shown in Fig. 1. Specifically, the Cu-Ga alloy sputtering target 10 shown in Fig. 1 has a cylindrical shape extending along an axis O. For example, an outer diameter D is in a range of 150 mm≤D≤200 mm, an inner diameter d is in a range of 120 nun≤d≤190 mm, and a length L in the direction of the axis O is in a range of 200 mm≤L≤2,000 mm.

An outer circumferential surface of the Cu-Ga alloy sputtering target 10 is a sputtering surface. The hollow portion corresponds to a space surrounded by an inner circumferential surface of the Cu-Ga alloy sputtering target 10. The outer circumferential surface and the inner circumferential surface of the Cu-Ga alloy sputtering target 10 are concentrically formed.

The Cu-Ga alloy sputtering target 10 according to the present embodiment contains, as a composition, Ga in a range of 20 atom% or greater and 40 atom% or less as a metal component, K and Na in a range of 0.05 atom% or greater and 1.0 atom% or less in total, and a remainder consisting of Cu and inevitable impurities.

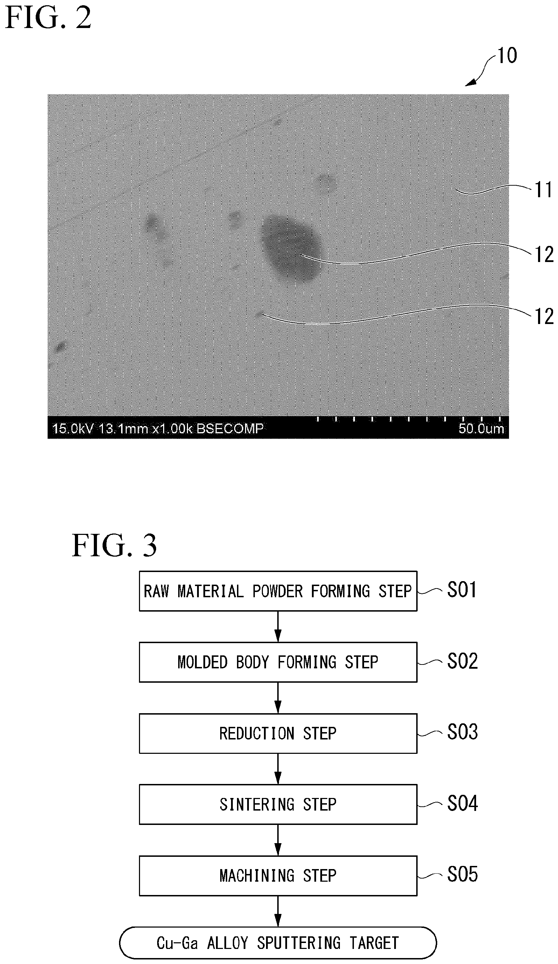

In the Cu-Ga alloy sputtering target 10 according to the present embodiment, as shown in Fig. 2, alkali metal salt grains 12 formed of a sodium salt or a potassium salt are dispersed in a matrix 11 of the Cu-Ga alloy, and have a maximum grain size of 30 $\mu$m or less.

In this embodiment, the average crystal grain size in the matrix 11 of the Cu-Ga alloy is 10 $\mu$m or greater and 150 $\mu$m or less.

The Cu-Ga alloy sputtering target 10 according to the present embodiment has a relative density of 97% or greater.

The Cu-Ga alloy sputtering target 10 according to the present embodiment has an oxygen content of 1,000 ppm by mass or less.

In the Cu-Ga alloy sputtering target 10 according to the present embodiment, in a case where the density is measured at a plurality of positions to obtain a maximum density $\rho_{max}$, a minimum density $\rho_{min}$, and an average density $\rho_{ave}$, and a larger one of $|\rho_{max}-\rho_{ave}|$ and $|\rho_{ave}-\rho_{min}|$ is represented by $\rho_A$, a variation in density defined by $\rho_A/\rho_{ave}\times100$ is 5% or less of the average $\rho_{ave}$.

In the Cu-Ga alloy sputtering target 10 according to the present embodiment, the Na content is measured at a plurality of positions, and both a difference between the measured maximum Na content and the average Na content and a difference between the average Na content and the minimum Na content are 0.05 atom% or less.

In the Cu-Ga alloy sputtering target 10 according to the present embodiment, the K content is measured at a plurality of positions, and both a difference between the measured maximum K content and the average K content and a difference between the average K content and the minimum K content are 0.05 atom% or less.

In this embodiment, as shown in Figs. 1(a) and 1(c), in total 9 sections obtained by dividing an optional cross section S along a radial direction of the cylinder into three (upper side: A/middle side: B/lower side: C) in the direction of the axis O and into three (inner circumferential side: 1/middle side: 2/outer circumferential side: 3) in the radial direction, the density, the Na content, and the K content were measured, and the above-described variation in density and the difference between the Na content and the K content were measured.

Hereinafter, the reasons why the total content of Na and K, the maximum grain size of the alkali metal salt grains 12, the relative density, the variation in relative density, the difference in the Na content, the difference in the K content, the oxygen content, and the crystal grain size in the matrix 11 of the Cu-Ga alloy are determined as described above in the Cu-Ga alloy sputtering target 10 according to the present embodiment will be shown.

(Total Content of Na and K)

In the Cu-Ga alloy sputtering target 10 according to the present embodiment, in a case where the total content of Na and K is less than 0.05 atom%, a Cu-Ga alloy film deposited has a small Na content and a small K content, and there is a concern that the conversion efficiency of a solar cell using the Cu-Ga alloy film cannot be improved.

On the contrary, in a case where the total content of Na and K is greater than 1.0 atom%, there is a concern that the sinterability may be reduced and the density may not be improved. In addition, there is a concern that the alkali metal salt grains 12 dispersed in the matrix 11 of the Cu-Ga alloy may be coarsened, and abnormal discharge may occur during sputtering.

Accordingly, in the present embodiment, the total content of Na and K is determined in a range of 0.05 atom% or greater and 1.0 atom% or less.

In order to further improve the conversion efficiency of a solar cell, the lower limit of the total content of Na and K is preferably 0.2 atom% or greater, and more preferably 0.4 atom% or greater.

In order to further improve the density and further suppress the occurrence of abnormal discharge, the upper limit of the total content of Na and K is preferably 0.8 atom% or less, and more preferably 0.6 atom% or less.

The Na content is preferably in a range of 0.1 atom% or greater and 0.5 atom% or less, and the K content is preferably in a range of 0.1 atom% or greater and 0.3 atom% or less.

(Alkali Metal Salt Grains)

The alkali metal salt grains formed of a sodium salt or a potassium salt are an insulating material. Accordingly, in a case where the alkali metal salt grains have a large grain size, abnormal discharge is likely to occur during deposition by sputtering. Accordingly, in the present embodiment, the maximum grain size of the alkali metal salt grains is limited to 30 μm or less.

In the present embodiment, samples were collected from total 9 sections obtained by dividing an optional cross section along the radial direction of the cylinder into 3 in the direction of the axis O (upper side: A/middle side: B/lower side: C) and into 3 in the radial direction (inner circumferential side: 1/middle side: 2/outer circumferential side: 3) as shown in Fig. 1(c), and a structure of the sample was observed at a magnification of 1,000 times to perform observation in 9 visual fields per sample, so that the maximum grain size of the alkali metal salt grains was measured in total 81 visual fields.

The maximum grain size of the alkali metal salt grains is preferably 20 μm or less, and more preferably 15 μm or less.

(Relative Density)

In the Cu-Ga alloy sputtering target 10 according to the present embodiment, in a case where the relative density is low, many voids are generated, and abnormal discharge is likely to occur due to the voids. Moreover, the strength is reduced and cracks are likely to occur.

Accordingly, in the present embodiment, the relative density is determined to be 97% or greater.

In order to further suppress the occurrence of abnormal discharge and the occurrence of cracks in the target due to the voids, the relative density of the Cu-Ga alloy sputtering target 10 is preferably 98% or greater, and more preferably 99% or greater.

(Variation in Density)

Since an unsintered portion where sintering has not been sufficiently performed has a low density, the strength is locally reduced in the low-density region. In addition, abnormal discharge is likely to occur at the time of sputtering due to the unsintered portion. Accordingly, there is a concern that the life of the Cu-Ga alloy sputtering target may be shortened.

Therefore, in the present embodiment, the above-described variation in density is limited to 5% or less of the average $\rho_{ave}$ so that no low-density portion locally exists.

The above-described variation in density is preferably 1 % or less of the average $\rho_{ave}$, and more preferably 0.5% or less of the average $\rho_{ave}$.

(Difference in Na Content/Difference in K Content)

In the Cu-Ga alloy sputtering target 10 according to the present embodiment, in a case where a difference between the average Na content and the minimum or maximum Na content and a difference between the average K content and the minimum or maximum K content are large, it is difficult to deposit a uniform Cu-Ga alloy film, and there is a concern that the performance of a solar cell using the Cu-Ga alloy film may vary.

Accordingly, in the present embodiment, the difference between the average Na content and the minimum or maximum Na content and the difference between the average K content and the minimum or maximum K content are limited to 0.05 atom% or less. The difference between the average Na content and the minimum or maximum Na content and the difference between the average K content and the minimum or maximum K content described above are preferably 0.02 atom% or less, and more preferably 0.01 atom% or less.

(Oxygen Content)

Since an oxide film remains on the surface of the raw material powder in an unsintered portion where sintering has not been sufficiently performed, the oxygen content in the sputtering target tends to increase. In a case where the number of unsintered portions is increased, the strength is locally reduced, and abnormal discharge is likely to occur during sputtering. Thus, there is a concern that the life of the Cu-Ga alloy sputtering target may be shortened.

Accordingly, in the present embodiment, the oxygen content is limited to 1,000 ppm by mass or less.

The oxygen content is preferably 900 ppm by mass or less, and more preferably 800 ppm by mass or less.

(Crystal Grain Size of Matrix of Cu-Ga Alloy)

In a case where the matrix 11 of the Cu-Ga alloy has a coarse crystal grain size and the sputtering proceeds, large irregularities are formed on the target sputtering surface, and causes abnormal discharge during sputtering. In order to reduce the crystal grain size of the matrix of the Cu-Ga alloy, it is necessary to reduce the grain size of the raw material powder, and there is a concern that the cost for manufacturing the sputtering target may be increased.

Due to the above reasons, in the present embodiment, the average crystal grain size of the matrix of the Cu-Ga alloy is determined in a range of 10 $\mu$m to 150 $\mu$m.

The lower limit of the average crystal grain size of the matrix 11 of the Cu-Ga alloy is preferably 15 $\mu$m or greater, and more preferably 30 $\mu$m or greater. The upper limit of the average crystal grain size of the matrix 11 of the Cu-Ga alloy is preferably 100 $\mu$m or less, and more preferably 75 $\mu$m or less.

Next, a method for manufacturing the Cu-Ga alloy sputtering target according to the present embodiment will be described with reference to Fig. 3.

(Raw Material Powder Forming Step S01)

First, a pure copper powder, a Cu-Ga alloy powder, a sodium salt powder, and a potassium salt powder are prepared.

In the pure copper powder, a median diameter D50 measured by a microtrack is 2 to 3 $\mu$m.

The Cu-Ga alloy powder is manufactured by an atomizing method, and a median diameter D50 thereof measured by a microtrack is 20 to 30 $\mu$m. The Ga content in the Cu-Ga alloy powder is preferably in a range of 40 mass% or greater and 60 mass% or less.

As the sodium salt powder, for example, sodium selenide, sodium sulfide, sodium chloride, sodium fluoride, or the like can be used. In the present embodiment, the maximum grain size of the sodium salt powder is 15 $\mu$m or less.

As the potassium salt powder, for example, potassium selenide, potassium sulfide, potassium chloride, potassium fluoride, or the like can be used. In the present embodiment, the maximum grain size of the potassium salt powder is 15 $\mu$m or less.

The above-described pure copper powder, Cu-Ga alloy powder, sodium salt powder, and potassium salt powder were weighed so as to obtain a predetermined composition and were mixed in an inert atmosphere (Ar atmosphere) using a mixing device such as a Henschel mixer, and a raw material powder was obtained.

The pure copper powder is preferably contained in a range of 10 mass% or greater and 15 mass% or less of the whole raw material powder.

(Molded Body Forming Step S02)

Next, a green compact (molded body) was formed from the raw material powder obtained as described above at a molding pressure of 500 kgf/cm$^2$ to 2,000 kgf/cm$^2$.

(Reduction Step S03)

The molded body obtained as described above is placed in a heating furnace with a reducing gas atmosphere and heated to perform dehydration and reduction of the molded body. For example, hydrogen, carbon monoxide, ammonia decomposition gas, or the like can be used as the reducing gas.

In a case where the heating temperature is lower than 550°C or the heating time is shorter than 15 hours, there is a concern that dehydration and reduction of the molded body may not be sufficiently performed, an oxide film may remain on the surface of the raw material powder, the sinterability in the subsequent sintering step S04 may be reduced, and the density cannot be improved. In a case where the heating temperature is higher than 650°C or the heating time is longer than 60 hours, there is a concern that the alkali metal salt may evaporate. In addition, there is a concern that the alkali metal salt may be segregated and coarsened.

Accordingly, in the present embodiment, the heating temperature in the reduction step S03 is set in a range of 550°C to 650°C, and the holding time at the heating temperature is set in a range of 15 hours or greater and 60 hours or less.

(Sintering Step S04)

Next, the molded body dehydrated and reduced as described above is placed in a sintering furnace and heated to sinter the molded body.

In the sintering step S04, sintering is performed in a reducing gas atmosphere such as hydrogen, carbon monoxide, or ammonia decomposition gas, the sintering temperature is in a range of 750°C to 850°C, and the holding time at the sintering temperature is in a range of 1 hour or greater and 10 hours or less.

Then, natural cooling is performed in the sintering furnace, and a sintered body is obtained.

(Machining Step S05)

Next, the above-described sintered body is subjected to lathe machining to obtain a Cu-Ga alloy sputtering target of a predetermined size.

As described above, the Cu-Ga alloy sputtering target of the present embodiment is manufactured.

According to the Cu-Ga alloy sputtering target 10 according to the present embodiment having the above-described configuration, since K and Na are contained in a range of 0.05 atom% or greater and 1.0 atom% or less in total, a Cu-Ga alloy film containing Na and K can be deposited.

In the Cu-Ga alloy sputtering target 10 according to the present embodiment, since alkali metal salt grains 12 formed of a sodium salt and a potassium salt are dispersed in the matrix 11 of the Cu-Ga alloy, and the alkali metal salt grains 12 have a maximum grain size of 30 $\mu$m or less, it is possible to suppress the occurrence of abnormal discharge caused by the alkali metal salt grains 12.

Since the Cu-Ga alloy sputtering target 10 according to the present embodiment has a relative density of 97% or greater, the strength of the target itself can be secured.

In this embodiment, since the variation in density is 5% or less of the average $\rho_{ave}$, there is no locally low-strength portion, and it is possible to suppress the occurrence of local cracks when the Cu-Ga alloy sputtering target 10 is used.

In the present embodiment, since both the difference between the measured average Na content and the minimum or maximum Na content and the difference between the measured average K content and the minimum or maximum K content are 0.05 atom% or less, a Cu-Ga alloy film uniformly containing Na and K can be deposited.

In the present embodiment, since the oxygen content is 1,000 ppm by mass or less, there are not many unsintered portions where sintering has not been sufficiently performed, and the density can be sufficiently increased. In this embodiment, since the average crystal grain size of the matrix 11 of the Cu-Ga alloy is in a range of 10 $\mu$m to 150 $\mu$m, no large irregularities are formed on the target sputtering surface even after the sputtering proceeds, and it is possible to suppress the occurrence of abnormal discharge.

The method for manufacturing the Cu-Ga alloy sputtering target according to the present embodiment includes the reduction step S03 for heating and reducing the molded body of the raw material powder in a reducing atmosphere, whereby even in a case where the molded body contains moisture due to moisture absorption, the moisture can be removed and an oxide film on the surface of the raw material powder can be removed in the reduction step S03. Accordingly, in the subsequent sintering step S04, sintering of the raw material powder grains can be promoted, and a high-density Cu-Ga alloy sputtering target 10 can be obtained.

Since the heating temperature is 550°C to 650°C in the reduction step S03 and the holding time at the heating temperature is 15 hours or greater and 60 hours or less, it is possible to suppress evaporation of the sodium salt and potassium salt powder contained in the molded body, and a Cu-Ga alloy sputtering target 10 containing Na and K can be obtained.

The embodiments of the present invention have been described as above, but the present invention is not limited thereto, and can be appropriately changed without departing from the technical idea of the present invention.

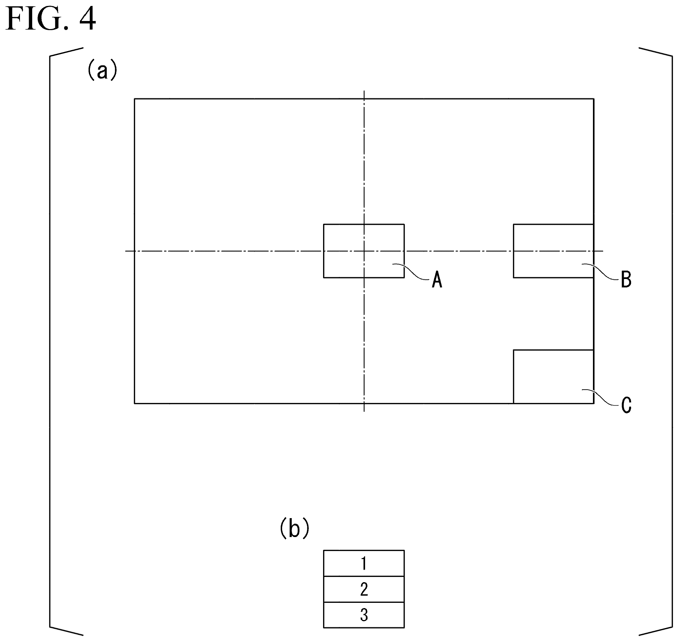

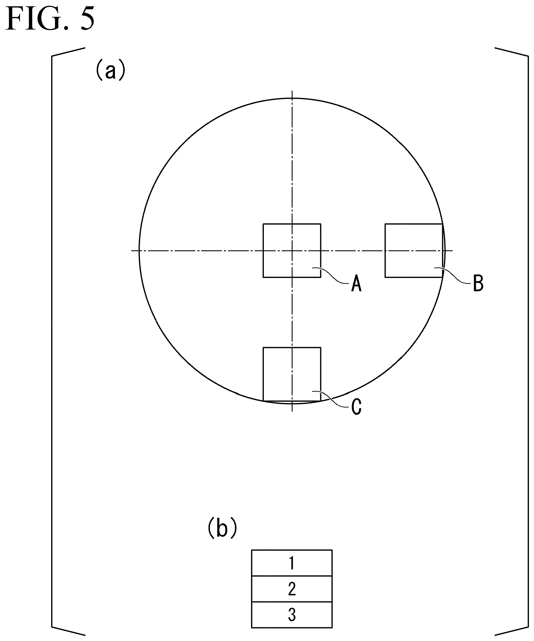

For example, in the present embodiment, a cylindrical sputtering target having a cylindrical sputtering surface as shown in Fig. 1 has been described as an example. However, the present invention is not limited thereto, and as shown in Fig. 4, a rectangular plate type sputtering target having a rectangular sputtering surface may be used. As shown in Fig. 5, a disk type sputtering target having a circular sputtering surface may be used.

As shown in Fig. 4, in a rectangular plate type sputtering target having a rectangular sputtering surface, it is preferable that, in total 9 sections obtained by dividing three portions of a central portion (A), an end portion (B), and a corner portion (C) in the rectangular surface into three (upper surface side: 1/middle side: 2/lower surface side: 3) in a thickness direction, the density, the Na content, and the K content are measured, and the above-described variation in density and the difference between the Na content and the K content are measured. In addition, it is preferable that structures of samples collected from the above-described 9 sections are observed at a magnification of 1,000 times to perform observation in 9 visual fields per sample, so that the maximum grain size of the alkali metal salt grains is measured in total 81 visual fields.

As shown in Fig. 5, in a disk type sputtering target having a circular sputtering surface, it is preferable that, in total 9 sections obtained by dividing three portions of a central portion (A) and outer circumferential portions (two portions (B and C) at an interval of 90° in a circumferential direction) in the circular surface into three (upper surface side: 1/middle side: 2/lower surface side: 3) in a thickness direction, the density, the Na content, and the K content are measured, and the above-described variation in density and the difference between the Na content and the K content are measured. In addition, it is preferable that structures of samples collected from the above-described 9 sections are observed at a magnification of 1,000 times to perform observation in 9 visual fields per sample, so that the maximum grain size of the alkali metal salt grains is measured in total 81 visual fields.

The rectangular plate type sputtering target and the disk type sputtering target can be sintered through pressing by a hot press or the like to increase the density. However, the cylindrical sputtering target described in the present embodiment is difficult to remove from the mold in a case where the sintering is performed through pressing. Accordingly, the molded body is preferably subjected to pressureless sintering as in the present invention.

[Examples]

Hereinafter, results of evaluation tests for evaluating the above-described Cu-Ga alloy sputtering target and method for manufacturing the Cu-Ga alloy sputtering target according to the present invention will be described.

A Cu-Ga alloy atomized powder (median diameter: 25 $\mu$m) having a composition shown in Table 1 was prepared as a raw material powder, and a sodium fluoride powder, a sodium chloride powder, a potassium fluoride powder, and a potassium chloride powder were prepared as alkali metal salt powders.

The above-described powders were respectively weighed to obtain a blending ratio shown in Table 1, and mixed in an Ar atmosphere using a Henschel mixer to obtain a raw material powder.

A mold was filled with the above-described raw material powder, and the raw material powder was pressed at a molding pressure of 1,500 kgf/cm$^2$ to obtain a cylindrical molded body.

The molded body was placed in a heating furnace, a reduction step was performed under the conditions shown in Table 1, and then a sintering step was performed under the conditions shown in Table 1.

The obtained sintered body was machined, and a cylindrical Cu-Ga alloy sputtering target having an outer diameter of 170 mm, an inner diameter of 135 mm, and a length of 230 mm was manufactured.

The obtained Cu-Ga alloy sputtering target was evaluated for the following items.

(Metal Component Contents/Variations in Na content and in K Content)

In the prepared Cu-Ga alloy sputtering target, samples were collected from the 9 sections shown in Fig. 1 (c), and pulverized and pre-treated with an acid. Then, composition of K and Na was analyzed by ICP-AES, and an average K content and an average Na content were calculated and described in Table 2.

As for Na and K, a larger one of the difference between the maximum value and the average and the difference between the average and the minimum value in a case where the measurement was performed in the 9 sections was shown as "Difference in Content" in Table 2.

(Alkali Metal Salt Grains)

In an atom mapping image obtained by a wavelength separation type X-ray detector, a region where Na and F (or Cl) and K and F (or Cl) coexisted was defined as alkali metal salt grains in the matrix of the Cu-Ga alloy. In the present example, samples were collected from total 9 sections obtained by dividing an optional cross section along the radial direction of the cylinder into 3 in the direction of the axis O (upper side: A/middle side: B/lower side: C) and into 3 in the radial direction (inner circumferential side: 1/middle side: 2/outer circumferential side: 3) as shown in Fig. 1(c), and a structure of the sample was observed at a magnification of 1,000 times to perform observation in 9 visual fields per sample, so that the maximum grain size of the alkali metal salt grains was measured in total 81 visual fields.

Each sample is observed by SEM, and the entire visual field is observed at a low magnification of 30 to 50 times to confirm a dark insulating region in the COMPO image. Regarding the largest grain in the entire visual field, the presence of the alkali salt was confirmed by EDS/element mapping, and the diameter of the inscribed circle of the largest grain was measured and defined as the "maximum grain size of the alkali metal salt grains". The evaluation results are shown in Table 2.

(Average Crystal Grain Size of Cu-Ga Alloy Phase)

In order to obtain an average crystal grain size of the Cu-Ga alloy phase as the matrix using the following calculation formula, a surface of a sample cut from the sputtering target was polished as a mirror surface and etched with an etching liquid containing a nitric acid and pure water, a microscopic image was taken by an optical microscope having a magnification within such a range of 50 to 1,000 times that it was possible to determine crystal grain boundaries, 10 straight lines were drawn to divide one side of the obtained image into 11 equal parts, and the number of crystal grains through which the 10 straight lines passed was counted.

$$\text{(average grain size)} = \text{(value obtained by correcting lengths of ten line segments}$$

$$\text{on image to actual length) / (number of Cu-Ga alloy phase crystal grains through which}$$

$$\text{ten line segments pass)}$$

An average grain size was calculated in the above-described 9 sections, and an average of the average grain sizes in the 9 sections was calculated as defined as the "average crystal grain size of the Cu-Ga alloy phase". As evaluation results, a case where the average crystal grain size is in a range of 10 to 150 $\mu$m is indicated by "A", and a case where the average crystal grain size is in a range of 10 to 150 $\mu$m is indicated by "B" in Table 2.

(Relative Density)

In a graph of the Ga content and the density, a density $\rho_{Cu}$ of pure copper = 8.96 g/cm$^3$ and a density $\rho_{CuGa}$ of the Cu-Ga alloy (Cu: 69.23 atom%, Ga: 30.77 atom%) = 8.47 g/cm$^3$ were connected by a straight line, and according to the composition (Ga content) of the Cu-Ga alloy, a value obtained by interpolation or extrapolation was used as a reference value to calculate a theoretical density according to amounts of NaF (theoretical density: 2.79 g/cm$^3$) and KF (theoretical density: 2.48 g/cm$^3$) added.

A weight of the Cu-Ga alloy sputtering target obtained by machining was measured and divided by a volume obtained from the shape to measure a density. A ratio between the measured density and the above-described theoretical density was calculated to obtain a relative density. The evaluation results are shown in Table 2.

(Variation in Density)

In the prepared Cu-Ga alloy sputtering target, samples were collected from the 9 sections shown in Fig. 1(c), and densities of the samples were measured by the Archimedes method.

A maximum density $\rho_{max}$, a minimum density $\rho_{min}$, and an average density $\rho_{ave}$ were obtained, and a variation in density defined by $\rho_A/\rho_{ave} \times 100$ was calculated where $\rho_A$ was a larger one of $|\rho_{max}-\rho_{ave}|$ and $|\rho_{ave}-\rho_{min}|$. The evaluation results are shown in Table 2.

(Oxygen Content)

In the analysis of O (oxygen), the measurement was performed by an infrared absorption method described in JIS Z 2613 "General Rules for Determination of Oxygen of Metal Materials" with the use of samples collected from the above-described 9 sections. The evaluation results are shown in Table 2.

(Abnormal Discharge)

The produced Cu-Ga alloy sputtering target was soldered to a Cu backing tube using In solder. A sputtering test was performed under the following conditions, and the number of times of abnormal discharge was measured. In order to remove the surface flaw of the Cu-Ga alloy sputtering target, pre-sputtering was performed under the following conditions, and then the number of times of abnormal discharges was measured. The evaluation results are shown in Table 2.

Sputtering Method: DC magnetron sputtering
Peak Vacuum Degree: $4 \times 10^{-4}$ Pa or less
Sputtering Ar pressure: 0.5 Pa
Pre-sputtering Power: 1.5 kWh
Sputtering Power: 3 kW
Target Rotation Speed: 10 rpm
Measurement of Abnormal Discharge: MICRO ARC MONITOR manufactured by LANDMARK TECHNOLOGY
Measurement Time: 2-hour continuous discharge

(Cracks During Machining)

It was confirmed whether cracks occurred during the production of the above-described Cu-Ga alloy sputtering target. The evaluation results are shown in Table 2.

(Cracks During Sputtering)

It was confirmed whether cracks occurred during the above-described sputtering test. The evaluation results are shown in Table 2.

[Table 1]

| | | Blending Ratio of Raw Materials (mol%) | | | | | Reduction Step | | | Sintering Step | | |
|---|---|---|---|---|---|---|---|---|---|---|---|---|
| | | Ga (atom%) | NaF Powder | KF Powder | NaCl Powder | KCl Powder | Atmosphere | Sintering Temperature (°C) | Holding Temperature (hr) | Atmosphere | Sintering Temperature (°C) | Holding Temperature (hr) |
| Invention Examples | 1 | 30 | 0.3 | 0.3 | 0.0 | 0.0 | $H_2$ 100% | 600 | 40 | $H_2$ 100% | 800 | 5 |
| | 2 | 30 | 0.3 | 0.3 | 0.0 | 0.0 | $H_2$ 100% | 600 | 15 | $H_2$ 100% | 800 | 5 |
| | 3 | 30 | 0.3 | 0.3 | 0.0 | 0.0 | $H_2$ 80% | 600 | 40 | $H_2$ 80% | 800 | 5 |
| | 4 | 30 | 0.3 | 0.3 | 0.0 | 0.0 | $H_2$ 75% | 600 | 40 | $H_2$ 75% | 800 | 5 |
| | 5 | 30 | 0.3 | 0.3 | 0.0 | 0.0 | CO 80% | 600 | 40 | CO 80% | 800 | 5 |
| | 6 | 30 | 0.2 | 0.2 | 0.0 | 0.0 | $H_2$ 100% | 600 | 40 | $H_2$ 100% | 800 | 5 |
| | 7 | 30 | 0.5 | 0.5 | 0.0 | 0.0 | $H_2$ 100% | 600 | 40 | $H_2$ 100% | 800 | 5 |
| | 8 | 25 | 0.5 | 0.5 | 0.0 | 0.0 | $H_2$ 100% | 600 | 50 | $H_2$ 100% | 800 | 10 |
| | 9 | 35 | 0.5 | 0.5 | 0.0 | 0.0 | $H_2$ 100% | 600 | 40 | $H_2$ 100% | 800 | 5 |
| | 10 | 20 | 0.3 | 0.3 | 0.0 | 0.0 | $H_2$ 100% | 600 | 40 | $H_2$ 100% | 800 | 5 |
| | 11 | 40 | 0.3 | 0.3 | 0.0 | 0.0 | $H_2$ 100% | 600 | 40 | $H_2$ 100% | 800 | 5 |
| | 12 | 30 | 0.025 | 0.025 | 0.0 | 0.0 | $H_2$ 100% | 600 | 40 | $H_2$ 100% | 800 | 5 |
| | 13 | 30 | 0.0 | 0.0 | 0.3 | 0.3 | $H_2$ 100% | 600 | 40 | $H_2$ 100% | 800 | 5 |
| | 14 | 30 | 0.2 | 0.2 | 0.0 | 0.0 | CO 60% | 600 | 60 | CO 60% | 800 | 5 |
| | 15 | 25 | 0.3 | 0.2 | 0.0 | 0.0 | $H_2$ 80% | 600 | 50 | $H_2$ 80% | 800 | 5 |
| | 16 | 20 | 0.2 | 0.1 | 0.1 | 0.0 | $H_2$ 50% | 600 | 60 | $H_2$ 50% | 800 | 10 |
| Comparative Examples | 1 | 30 | 0.3 | 0.3 | 0.0 | 0.0 | $H_2$ 100% | 600 | 10 | $H_2$ 100% | 800 | 5 |
| | 2 | 30 | 0.3 | 0.5 | 0.0 | 0.0 | $H_2$ 100% | 600 | 80 | $H_2$ 100% | 800 | 15 |
| | 3 | 30 | 0.6 | 0.6 | 0.0 | 0.0 | $H_2$ 100% | 600 | 40 | $H_2$ 100% | 800 | 5 |
| | 4 | 30 | 0.01 | 0.01 | 0.0 | 0.0 | $H_2$ 100% | 600 | 40 | $H_2$ 100% | 800 | 5 |
| | 5 | 30 | 0.3 | 0.3 | 0.0 | 0.0 | Air | 600 | 40 | Air | 800 | 5 |
| | 6 | 30 | 0.3 | 0.3 | 0.0 | 0.0 | $N_2$ 100% | 600 | 40 | $N_2$ 100% | 800 | 5 |

[Table 2]

| Invention Examples | | Composition of Alkali Metal (atom%) | | | | Maximum Grain Size of Alkali Metal Salt (μm) | Average Crystal Grain Size of Cu Alloy Phase 10 to 150 μm | Relative Density (%) | Variation in Density ($\times \rho_{ave}$) | Oxygen Content (ppm by mass) | Number of Times of Abnormal Discharge (times) | Cracks During Machining | Cracks During Sputtering |
|---|---|---|---|---|---|---|---|---|---|---|---|---|---|
| | | Average | | Variation | | | | | | | | | |
| | | Na | K | Na | K | | | | | | | | |
| Invention Examples | 1 | 0.3 | 0.3 | 0.02 | 0.01 | 15 | A | 98 | 0.5 | 730 | 10 | None | None |
| | 2 | 0.3 | 0.3 | 0.02 | 0.02 | 12 | A | 97 | 0.5 | 800 | 5 | None | None |
| | 3 | 0,3 | 0.3 | 0.02 | 0.02 | 13 | A | 97 | 0.5 | 900 | 100 | None | None |
| | 4 | 0.3 | 0.3 | 0.01 | 0.02 | 12 | A | 97 | 0.8 | 990 | 5 | None | None |
| | 5 | 0.3 | 0.3 | 0.01 | 0.02 | 10 | A | 97 | 0.5 | 900 | 3 | None | None |
| | 6 | 0.3 | 0.3 | 0.02 | 0.05 | 12 | A | 98 | 0.3 | 300 | 3 | None | None |
| | 7 | 0.5 | 0.5 | 0.03 | 0.04 | 18 | A | 97 | 0.6 | 970 | 120 | None | None |
| | 8 | 0.5 | 0.5 | 0.03 | 0.04 | 27 | A | 98 | 0.2 | 600 | 250 | None | None |
| | 9 | 0.5 | 0.5 | 0.02 | 0.05 | 17 | A | 97 | 0.5 | 950 | 45 | None | None |
| | 10 | 0.3 | 0.3 | 0.02 | 0.03 | 16 | A | 98 | 0.1 | 580 | 30 | None | None |
| | 11 | 0.3 | 0.3 | 0.02 | 0.02 | 15 | A | 97 | 0.6 | 930 | 18 | None | None |
| | 12 | 0.025 | 0.025 | 0.01 | 0.01 | 10 | A | 99 | 0.1 | 150 | 0 | None | None |
| | 13 | 0.3 | 0.3 | 0.02 | 0.03 | 13 | A | 97 | 0.5 | 770 | 22 | None | None |
| | 14 | 0.2 | 0.2 | 0.02 | 0.03 | 12 | A | 97 | 0.7 | 910 | 12 | None | None |
| | 15 | 0.3 | 0.2 | 0.01 | 0.02 | 12 | A | 97 | 0.5 | 975 | 17 | None | None |
| | 16 | 0.3 | 0.1 | 0.02 | 0.00 | 10 | A | 97 | 0.8 | 850 | 0 | None | None |

(continued)

| | | Composition of Alkali Metal (atom%) | | | | Maximum Grain Size of Alkali Metal Salt (μm) | Average Crystal Grain Size of Cu Alloy Phase 10 to 150 μm | Relative Density (%) | Variation in Density ($\times \rho_{ave}$) | Oxygen Content (ppm by mass) | Number of Times of Abnormal Discharge (times) | Cracks During Machining | Cracks During Sputtering |
|---|---|---|---|---|---|---|---|---|---|---|---|---|---|
| | | Average | | Variation | | | | | | | | | |
| | | Na | K | Na | K | | | | | | | | |
| Comparative Example | 1 | 0.3 | 0.3 | 0.01 | 0.01 | 10 | A | 96 | 0.5 | 1700 | 35 | None | Cracked |
| | 2 | 0.2 | 0.2 | 0.05 | 0.05 | 45 | A | 98 | 0.3 | 400 | 1500 | None | Cracked |
| | 3 | 0.6 | 0.5 | 0.03 | 0.06 | 18 | A | 96 | 0.8 | 1200 | - | Cracked | - |
| | 4 | 0.01 | 0.01 | 0.00 | 0.00 | 10 | B | 99 | 0.2 | 800 | 1200 | None | Cracked |
| | 5 | 0.3 | 0.3 | 0.02 | 0.02 | 10 | A | 80 | 1.0 | 2500 | - | Machining is not possible | - |
| | 6 | 0.3 | 0.3 | 0.01 | 0.02 | 10 | A | 81 | 1.0 | 2000 | - | Machining is not possible | - |

In Comparative Example 1 in which the holding time in the reduction step was short, the relative density was as low as 96%. In addition, the oxygen concentration was as high as 1,700 ppm by mass. Cracks occurred during sputtering, and it was not possible to stably deposit a film by sputtering. The reason for this is presumed to be that sintering did not proceed due to insufficient reduction.

In Comparative Example 2 in which the holding time in the reduction step and the sintering step was long, the maximum grain size of the alkali salt grains was as large as 45 μm. The number of times of abnormal discharge was as large as 1,500, and it was not possible to stably deposit a film by sputtering. The reason for this is presumed to be that the alkali salt grains agglomerated and were coarsened.

In Comparative Example 3 in which the total content of Na and K was 1.1 atom%, the relative density was as low as 96%. In addition, the oxygen concentration was as high as 1,200 ppm by mass. Since cracks occurred during machining, the sputtering test was not performed.

In Comparative Example 4 in which the total content of Na and K was 0.02 atom%, the average crystal grain size of the Cu-Ga alloy phase was greater than 150 μm. The number of times of abnormal discharge was as large as 1,200, and it was not possible to stably deposit a film by sputtering.

In Comparative Example 5 in which the sintering was performed in an air atmosphere, the relative density was as low as 80%. In addition, the oxygen concentration was as high as 2,500 ppm by mass. Furthermore, the sputtering target could not be machined. Accordingly, the sputtering test was not performed.

In Comparative Example 6 in which the sintering was performed in a nitrogen atmosphere, the relative density was as low as 81%. In addition, the oxygen concentration was as high as 2,000 ppm by mass. Furthermore, the sputtering target could not be machined. Accordingly, the sputtering test was not performed.

In Invention Examples 1 to 16, the relative density was as high as 97% or greater even in a case where Na and K were contained. The occurrence of abnormal discharge was also suppressed, and it was possible to stably deposit a film by sputtering.

In Invention Example 13, a chloride was used as the alkali salt, but the effects of the present invention were recognized as in Invention Examples 1 to 12, 14, and 15 using a fluoride.

Even in a case where a fluoride and a chloride were added as the alkali salt as shown in Invention Example 16, the effects of the present invention were recognized.

From the above facts, it has been confirmed that according to the present invention, it is possible to provide a Cu-Ga alloy sputtering target containing Na and K, having a high density, suppressing the occurrence of abnormal discharge, and achieving a longer life, and a method for manufacturing the Cu-Ga alloy sputtering target.

[Industrial Applicability]

According to the present invention, it is possible to provide a Cu-Ga alloy sputtering target containing Na and K, having a high density, suppressing the occurrence of abnormal discharge, and achieving a longer life, and a method for manufacturing the Cu-Ga alloy sputtering target.

[Reference Signs List]

10    Cu-Ga alloy sputtering target
11    matrix
12    alkali metal salt grains

**Claims**

**1.** A Cu-Ga alloy sputtering target comprising, as a composition:

Ga in a range of 20 atom% or greater and 40 atom% or less as a metal component;
Na and K in a range of 0.05 atom% or greater and 1.0 atom% or less in total; and
a remainder consisting of Cu and inevitable impurities,

wherein alkali metal salt grains formed of a sodium salt or a potassium salt are dispersed in a matrix of the Cu-Ga alloy,
the alkali metal salt grains have a maximum grain size of 30 μm or less, and
a relative density is 97% or greater.

2. The Cu-Ga alloy sputtering target according to claim 1,
   wherein in a case where a density is measured at a plurality of positions to obtain a maximum density $\rho_{max}$, a minimum density $\rho_{min}$, and an average density $\rho_{ave}$, and a larger one of $|\rho_{max}-\rho_{ave}|$ and $|\rho_{ave}-\rho_{min}|$ is represented by $\rho_A$, a variation in density defined by $\rho_A/\rho_{ave}\times100$ is 5% or less of the average $\rho_{ave}$.

3. The Cu-Ga alloy sputtering target according to claim 1 or 2,
   wherein a Na content is measured at a plurality of positions, and both a difference between a measured maximum Na content and an average Na content and a difference between the average Na content and a minimum Na content are 0.05 atom% or less.

4. The Cu-Ga alloy sputtering target according to any one of claims 1 to 3,
   wherein a K content is measured at a plurality of positions, and both a difference between a measured maximum K content and an average K content and a difference between the average K content and a minimum K content are 0.05 atom% or less.

5. The Cu-Ga alloy sputtering target according to any one of claims 1 to 4,
   wherein an oxygen content is 1,000 ppm by mass or less.

6. A method for manufacturing the Cu-Ga alloy sputtering target according to any one of claims 1 to 5, the method comprising:

   a raw material powder forming step of obtaining a raw material powder including a sodium salt powder and a potassium salt powder;
   a molded body forming step of forming a molded body of the raw material powder;
   a reduction step of heating and reducing the molded body in a reducing atmosphere; and
   a sintering step of subjecting the molded body after the reduction step to pressureless sintering,
   wherein in the reduction step, a heating temperature is in a range of 550°C or greater and 650°C or less, and a holding time at the heating temperature is in a range of 15 hours or greater and 60 hours or less, and
   in the sintering step, a sintering temperature is in a range of 750°C or more and 850°C or less, and a holding time at the sintering temperature is in a range of 1 hour or greater and 10 hours or less.

# FIG. 1

(a)

(b)

(C)

FIG. 2

15.0kV 13.1mm x1.00k BSECOMP          50.0um

FIG. 3

```
┌──────────────────────────────────┐
│ RAW MATERIAL POWDER FORMING STEP │──S01
└──────────────────────────────────┘
              ↓
┌──────────────────────────────────┐
│      MOLDED BODY FORMING STEP     │──S02
└──────────────────────────────────┘
              ↓
┌──────────────────────────────────┐
│          REDUCTION STEP           │──S03
└──────────────────────────────────┘
              ↓
┌──────────────────────────────────┐
│          SINTERING STEP           │──S04
└──────────────────────────────────┘
              ↓
┌──────────────────────────────────┐
│          MACHINING STEP           │──S05
└──────────────────────────────────┘
              ↓
┌──────────────────────────────────┐
│    Cu-Ga ALLOY SPUTTERING TARGET  │
└──────────────────────────────────┘
```

FIG. 4

(a)

A

B

C

(b)

| 1 |
|---|
| 2 |
| 3 |

FIG. 5

(a)

(b)

**INTERNATIONAL SEARCH REPORT**

| International application No. |
| --- |
| PCT/JP2018/046519 |

A. CLASSIFICATION OF SUBJECT MATTER
Int.Cl. C23C14/34(2006.01)i, B22F3/10(2006.01)i, C22C1/04(2006.01)i,
C22C1/05(2006.01)i, C22C9/00(2006.01)i, H01L31/0749(2012.01)i
According to International Patent Classification (IPC) or to both national classification and IPC

B. FIELDS SEARCHED

Minimum documentation searched (classification system followed by classification symbols)
Int.Cl. C23C14/34, B22F3/10, C22C1/04, C22C1/05, C22C9/00, H01L31/0749

Documentation searched other than minimum documentation to the extent that such documents are included in the fields searched
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)
DWPI (Derwent Innovation)

C. DOCUMENTS CONSIDERED TO BE RELEVANT

| Category* | Citation of document, with indication, where appropriate, of the relevant passages | Relevant to claim No. |
| --- | --- | --- |
| Y | JP 2011-117077 A (MITSUBISHI MATERIALS CORP.) 16 June 2011, claims, paragraphs [0008]-[0012], [0018]-[0020], examples, tables 2, 3 & US 2012/0217157 A1, claims, paragraphs [0010]-[0020], examples, tables 2, 3 & WO 2011/055537 A1 & EP 2402482 A1 & KR 10-2011-0113213 A & TW 201126002 A & CN 102395702 A | 1-6 |
| Y | JP 2012-233230 A (MITSUBISHI MATERIALS CORP.) 29 November 2012, claims, paragraphs [0025], [0033], [0039], examples, tables 2, 3 & US 2014/0034491 A1, claims, paragraphs [0046]-[0047], [0063], [0071], examples, tables 2, 3 & WO 2012/147985 A1 & EP 2703519 A1 & TW 201307595 A & CN 103534381 A & KR 10-2014-0027964 A | 1-6 |

☒ Further documents are listed in the continuation of Box C.    ☐ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 05 February 2019 (05.02.2019) | 12 March 2019 (12.03.2019) |

| Name and mailing address of the ISA/ | Authorized officer |
| --- | --- |
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

International application No.

PCT/JP2018/046519

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2016-28173 A (MITSUBISHI MATERIALS CORP.) 25 February 2016, claims, paragraphs [0014], [0016], [0023], tables 2, 3 & US 2017/0178876 A1, claims, paragraphs [0025], [0027], [0034], examples, tables 2, 3 & WO 2016/006600 A1 & TW 201610193 A & CN 106170581 A | 1-6 |
| A | JP 2015-30870 A (MITSUBISHI MATERIALS CORP.) 16 February 2015, entire text & US 2016/0208376 A1 & WO 2015/016153 A1 & EP 3029171 A1 & TW 201510250 A & CN 105358733 A | 1-6 |
| P, A | WO 2018/021105 A1 (MITSUBISHI MATERIALS CORP.) 01 February 2018, entire text & JP 2018-24933 A & TW 201812061 A | 1-6 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017246340 A
- JP 2015140452 A

- JP 2016028173 A

**Non-patent literature cited in the description**

- **ADRIAN CHIRILA et al.** Potassium-induced surface modification of Cu (In, Ga) Se2 thin films for high-efficiency solar cells. *NATURE MATERALS,* 2013, vol. 12